(19) Europäisches Patentamt

European Patent Office

Office européen des brevets

(11) **EP 1 684 364 A2**

(12) **EUROPEAN PATENT APPLICATION**

(43) Date of publication:
26.07.2006 Bulletin 2006/30

(51) Int Cl.:
*H01L 41/187* (2006.01)        *C04B 35/493* (2006.01)

(21) Application number: 06250281.0

(22) Date of filing: 19.01.2006

(84) Designated Contracting States:
**AT BE BG CH CY CZ DE DK EE ES FI FR GB GR HU IE IS IT LI LT LU LV MC NL PL PT RO SE SI SK TR**
Designated Extension States:
**AL BA HR MK YU**

(30) Priority: 20.01.2005 JP 2005013241

(71) Applicant: **NGK INSULATORS, LTD.**
**Nagoya-City, Aichi Pref. 467-8530 (JP)**

(72) Inventors:
• **Shimizu, Hideki**
**Nagoya City**
**Aichi-ken 467-8530 (JP)**

• **Ebigase, Takashi**
**Nagoya City**
**Aichi-ken 467-8530 (JP)**
• **Kitagawa, Mutsumi**
**Nagoya City**
**Aichi-ken 467-8530 (JP)**
• **Kashiwaya, Toshikatsu**
**Nagoya City**
**Aichi-ken 467-8530 (JP)**

(74) Representative: **Paget, Hugh Charles Edward et al**
**Mewburn Ellis LLP**
**York House**
**23 Kingsway**
**London WC2B 6HP (GB)**

(54) **Piezoelectric device**

(57) There is disclosed a piezoelectric device which has a remarkably high piezoelectric characteristic and which is superior in a vibration transmitting property between a substrate and a piezoelectric portion and in which linearity of a flexural displacement with respect to a voltage is high up to a high voltage region and which exhibits a high durability even in a case where the device is used with a large flexural displacement for a long period. The piezoelectric device is provided with: a substrate 2 made of a ceramic; a piezoelectric portion 1 constituted of a piezoelectric porcelain composition containing as a major component a $Pb(Mg, Ni)_{1/3}Nb_{2/3}O_3\text{-}PbZrO_3\text{-}PbTiO_3$ ternary solid solution system composition represented by a predetermined formula; and an electrode 3 electrically connected to the piezoelectric portion 1, and the piezoelectric portion 1 is solidly attached onto the substrate 2 directly or via the electrode 3.

FIG.2(a)

(Cont. next page)

EP 1 684 364 A2

FIG.2(b)

## Description

BACKGROUND OF THE INVENTION

Field of the Invention

The present invention relates to a piezoelectric device, more particularly to a piezoelectric device which exhibits a remarkably high piezoelectric characteristic and whose displacement increase ratio at a time when a large electric field is applied is large in a case where the device is used as an actuator and whose resolution at a time when a large force is applied is high in a case where the device is used as a sensor.

Description of the Related Art

Heretofore, a piezoelectric device has been utilized in an ink jet printer head, a speaker, a microphone or the like. In the piezoelectric device, a piezoelectric portion made of a piezoelectric porcelain composition and an electrode electrically connected to the piezoelectric portion are disposed on a substrate made of a ceramic. It is to be noted that various improvements of the piezoelectric porcelain composition constituting the piezoelectric portion have been disclosed.

For example, there is disclosed a Pb $(Mg_{1/3}Nb_{2/3})$ $O_3$-$PbTiO_3$-$PbZrO_3$ ternary solid solution system composition or a piezoelectric porcelain composition in which a part of Pb in the composition is replaced with Sr, La or the like (see, e.g., Japanese Patent Publication No. 44-17103 and Japanese Patent Publication No. 45-8145). According to these documents, as to a piezoelectric body itself which is the most important portion that determines a piezoelectric characteristic of the piezoelectric device, the piezoelectric device having a superior piezoelectric characteristic (e.g., piezoelectric d constant) is expected to be obtained.

The piezoelectric device in which the piezoelectric porcelain composition is used is manufactured by laminating a piezoelectric material constituted of the piezoelectric porcelain composition on the ceramic substrate, and thereafter thermally treating the material. However, since denseness of the resultant piezoelectric portion is low, a flexural displacement is sometimes reduced. A problem has been pointed out that dielectric breakdown easily occurs in a portion having a low denseness in a case where a voltage is applied. This problem is remarkable especially in the piezoelectric device having a multilayer structure in which a plurality of piezoelectric portions are alternately sandwiched and disposed between an anode and a cathode of an electrode, and there has been a strong desire for improvement of the device.

Moreover, a sufficient piezoelectric characteristic cannot be necessarily obtained in the piezoelectric portion made of the piezoelectric porcelain composition disclosed in Japanese Patent Publication No. 44-17103 and Japanese Patent Publication No. 45-8145 described above in some case. Furthermore, when the voltage is raised in order to increase the flexural displacement, there is a disadvantage that a ratio of increase of the flexural displacement is very small as compared with the increased voltage on a high-electric-field of 4 kV/mm or more. When such piezoelectric portion is inflected on such conditions as to cause a large displacement for a long period, the piezoelectric portion breaks or peeling occurs between the piezoelectric portion and the ceramic substrate or between the piezoelectric portion and the electrode in some case. Therefore, it cannot be necessarily said that the device is sufficient in respect of durability.

There is disclosed a piezoelectric device in which the piezoelectric material constituted of the piezoelectric porcelain composition is thermally treated to laminate the prepared piezoelectric portion on the ceramic substrate in order to enhance the durability (see, e.g., Japanese Patent Application Laid-Open No. 11-29357). However, in this piezoelectric device, when the piezoelectric portion is laminated onto the ceramic substrate, it is necessary to use an inorganic or organic adhesive. Therefore, the adhesive sometimes obstructs vibration transmission between the ceramic substrate and the piezoelectric portion, or an adhesive component sometimes permeates the piezoelectric portion or the ceramic substrate to deteriorate characteristics. As to this piezoelectric device, the piezoelectric porcelain composition itself constituting the piezoelectric portion is not considered at all. Therefore, in the same manner as in the above-described piezoelectric device, there is a problem that the sufficient piezoelectric characteristic cannot be obtained, and especially the increase ratio of the flexural displacement in a high-voltage region is very small as compared with the increase of the voltage. Furthermore, there is a problem that the durability is insufficient.

SUMMARY OF THE INVENTION

The present invention has been developed in view of such a conventional technical problem, and an object thereof is to provide a piezoelectric device which has a remarkable high piezoelectric characteristic and which is superior in vibration transmitting property between a substrate and a piezoelectric portion and whose flexural displacement linearity with respect to a voltage is high until a high-voltage region is reached and which exhibits a high durability even in a case where the device is used with a large flexural displacement for a long period.

As a result of intensive investigation by the present inventors in order to achieve the object, it has been found that a dense piezoelectric portion is obtained which has a uniform domain structure even when the portion is thermally treated after laminating the portion on a substrate in a case where a piezoelectric material is used which is constituted of a piezoelectric porcelain composition having a specific composition formed by replacing with Ni a part of Mg of a Pb $(Mg_{1/3}Nb_{2/3}) O_3$-$PbZrO_3$-$PbTiO_3$ ternary solid solution system composition.

That is, according to the present invention, there are provided the following piezoelectric device.

[1] A piezoelectric device comprising:

a substrate made of a ceramic;
a piezoelectric portion made of a first piezoelectric porcelain composition containing as a major component a first $Pb(Mg, Ni)_{1/3}Nb_{2/3}O_3$.- $PbZrO_3$- $PbTiO_3$ ternary solid solution system composition represented by the following formula (1); and an electrode electrically connected to the piezoelectric portion, the piezoelectric portion being solidly attached on the substrate directly or via the electrode,

$$Pb_x\{ (Mg_{1-y}Ni_y)_{(1/3)}x_aNb_{2/3}\}_bTi_cZr_dO_3 \ \ \cdots \ \ (1),$$

wherein $0.95 \leq x \leq 1.05$, $0.20 < y \leq 0.50$, $0.90 \leq a \leq 1.10$, and b, c and d are decimals (with the proviso that (b+c+d) = 1.000) in a range surrounded with (b, c, d) = (0.550, 0.425, 0.025), (0.550, 0.325, 0.125), (0.375, 0.325, 0.300), (0.050, 0.425, 0.525), (0.050, 0.525, 0.425), and (0.375, 0.425, 0.200) in a coordinate whose coordinate axes are the b, c, and d (three-component composition diagram).

[2] The piezoelectric device according to the paragraph [1], comprising:

a plurality of piezoelectric portions; and
a plurality of electrodes,
the plurality of piezoelectric portions being alternately sandwiched and laminated between the electrodes, and
a lowermost piezoelectric portion positioned in a lowermost layer among the piezoelectric portions being solidly attached onto the substrate directly or via a lowermost electrode positioned in the lowermost layer among the electrodes.

[3] The piezoelectric device according to the paragraphs [1] or [2], wherein the piezoelectric portion is formed by successively laminating and sintering a second piezoelectric porcelain composition containing as a major component a second $Pb (Mg, Ni)_{1/3}Nb_{2/3}O_3$-$PbZrO_3$-$PbTiO_3$ ternary solid solution system composition represented by the following formula (2), and a third piezoelectric porcelain composition containing as a major component a $PbMg_{1/3}Nb_{2/3}O_3$-$PbZrO_3$-$PbTiO_3$ ternary solid solution system composition represented by the following formula (3) and containing 0.1 to 3.0% by mass of NiO,

$$Pb_x\{ (Mg_{1-y}Ni_y)_{(1/3)}x_aNb_{2/3}\}_bTi_cZr_dO_3 \ \ \cdots \ \ (2),$$

wherein $0.95 \leq x \leq 1.05$, $0.05 \leq y \leq 0.20$, $0.90 \leq a \leq 1.10$, and b, c, and d are decimals (with the proviso that (b+c+d) = 1.000) in a range surrounded with (b, c, d) = (0.550, 0.425, 0.025), (0.550, 0.325, 0.125), (0.375, 0.325, 0.300), (0.050, 0.425, 0.525), (0.050, 0.525, 0.425), and (0.375, 0.425, 0.200) in a coordinate whose coordinate axes are the b, c, and d,

$$Pb_x(Mg_{y/3}Nb_{2/3})_aTi_bZr_dO_3 \ \ \cdots \ \ (3),$$

wherein $0.95 \leq x \leq 1.05$, $0.95 \leq y \leq 1.05$, and a, b, and c are decimals (with the proviso that a+b+c = 1.00) in a range surrounded with (a, b, c) = (0.550, 0.425, 0.025), (0.550, 0.325, 0.125), (0.375, 0.325, 0.300), (0.050, 0.425, 0.525), (0.050, 0.525, 0.425), and (0.375, 0.425, 0.200) in a coordinate whose coordinate axes are the a, b, and c.

[4] The piezoelectric device according to any one of the paragraphs [1] or [3], wherein the first piezoelectric porcelain composition is crystal grains having an average grain diameter of 1 to 10 $\mu$m and a maximum grain diameter of five times or less as much as the average grain diameter.

[5] The piezoelectric device according to the paragraph [4], wherein grains (NiO grains) containing NiO as a major component are present inside the crystal grains, or in the surfaces or the insides of the crystal grains.

[6] The piezoelectric device according to the paragraph [5], wherein the NiO grains contain MgO as solid solution.

The piezoelectric device of the present invention has a remarkable high piezoelectric characteristic, is superior in vibration transmitting property between a substrate and a piezoelectric portion, and produces effects that linearity of a flexural displacement with respect to a voltage is high until a high-voltage region is reached and that a high durability is exhibited even in a case where the device is used with a large flexural displacement for a long period.

BRIEF DESCRIPTION OF THE DRAWINGS

FIG. 1(a) is a plan view schematically showing one embodiment of a piezoelectric device according to the present invention;
FIG. 1(b) is a sectional view along X-X' of FIG. 1(a);
FIG. 2(a) is a plan view schematically showing another embodiment of the piezoelectric device according to the present invention;
FIG. 2(b) is a sectional view along X-X' of FIG. 2(a);
FIG. 3(a) is a plan view schematically showing still another embodiment of the piezoelectric device according to the present invention;
FIG. 3(b) is a sectional view along X-X' of FIG. 3(a);
FIG. 4(a) is a plan view schematically showing a further embodiment of the piezoelectric device according to the present invention;
FIG. 4(b) is a sectional view along X-X' of FIG. 4 (a) ;
FIG. 5(a) is a plan view schematically showing a further embodiment of the piezoelectric device according to the present invention;
FIG. 5(b) is a sectional view along X-X' of FIG. 5(a);
FIG. 6 is a sectional view schematically showing a further embodiment of the piezoelectric device according to the present invention;
FIG. 7 is a sectional view schematically showing a further embodiment of the piezoelectric device according to the present invention;
FIG. 8 is a sectional view schematically showing a further embodiment of the piezoelectric device according to the present invention;
FIG. 9 is a sectional view schematically showing a further embodiment of the piezoelectric device according to the present invention; and
FIG. 10 is a sectional view showing a still further embodiment of the piezoelectric device according to the present invention in more detail.

DESCRIPTION OF THE PREFERRED EMBODIMENT

A best mode for carrying out the present invention will be described hereinafter, but it should be understood that the present invention is not limited to the following embodiments, and the present invention includes appropriate alterations, modifications and the like added to the following embodiments based on ordinary knowledge of a person skilled in the art without departing from the scope of the present invention.

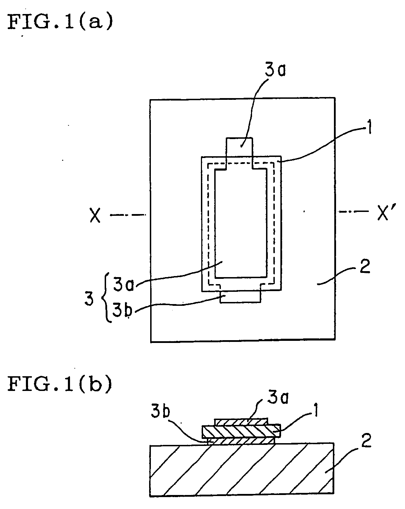

FIG. 1(a) is a plan view schematically showing one embodiment of a piezoelectric device of the present invention. FIG. 1(b) is a sectional view along X-X' of FIG. 1(a). As shown in FIGS. 1(a) and 1(b), a piezoelectric device of the present embodiment is provided with: a substrate 2 made of a ceramic; a piezoelectric portion 1 constituted of a specific piezoelectric porcelain composition; and an electrode 3 (upper electrode 3a, lower electrode 3b). The piezoelectric portion 1 is solidly attached on the substrate 2 directly or via the electrode 3 (lower electrode 3b). Each constituting element will be described hereinafter in more detail.

In the present embodiment, the substrate 2 constituting the piezoelectric device is made of a ceramic. From respects of heat resistance, chemical stability, and insulating property, this ceramic preferably contains at least one kind selected from the group consisting of stabilized zirconium oxide, aluminum oxide, magnesium oxide, mullite, aluminum nitride, silicon nitride, and glass. Above all, stabilized zirconium oxide is preferably contained from a viewpoint that its mechanical strength is large and its tenacity is superior.

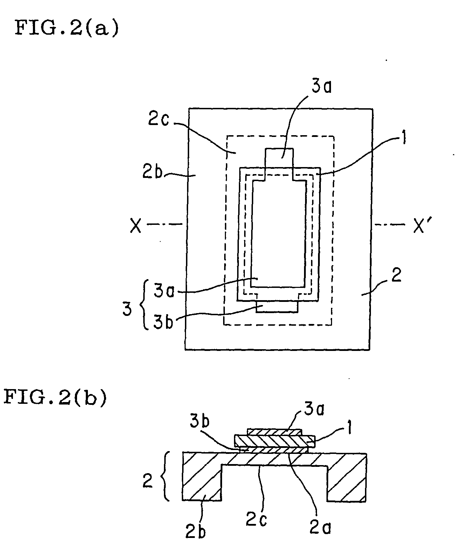

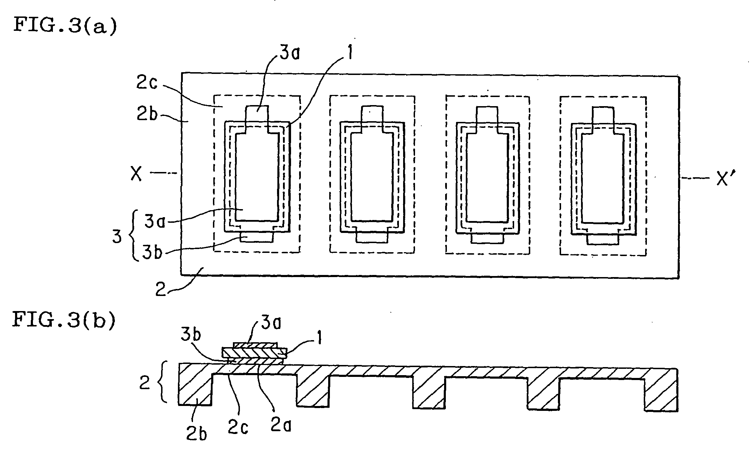

In the present embodiment, a thickness of the substrate 2 constituting the piezoelectric device is preferably 3 $\mu$m to 1 mm, more preferably 5 to 500 $\mu$m, and especially preferably 7 to 200 $\mu$m. When the thickness of the substrate is less than 3 $\mu$m, the mechanical strength of the piezoelectric device sometimes weakens. On the other hand, when the thickness exceeds 1 mm, rigidity of the substrate with respect to a contraction stress of the piezoelectric portion becomes excessively large, and a flexural displacement of the piezoelectric device is sometimes reduced in a case where a voltage is applied to the piezoelectric portion. However, as shown in FIGS. 2(a) and 2(b), the substrate 2 may be formed into a shape provided with: a thin portion 2c in which the thickness of the region substantially corresponding to a solidly attached surface 2a between the piezoelectric portion 1 or the electrode 3 (lower electrode 3b) and the substrate is set to the above-described thickness; and a thick portion 2b in which the thickness of the region substantially corresponding to a portion other than the solidly attached surface 2a is set to be larger than that of the thin portion 2c. Since the substrate 2 is formed in such shape, the flexural displacement of the piezoelectric device can be enlarged more, and even the mechanical strength can be enhanced. As shown in FIGS. 3(a) and 3(b), a plurality of constituting unit each including the piezoelectric portion 1 and the electrode 3 may be disposed on one common substrate 2.

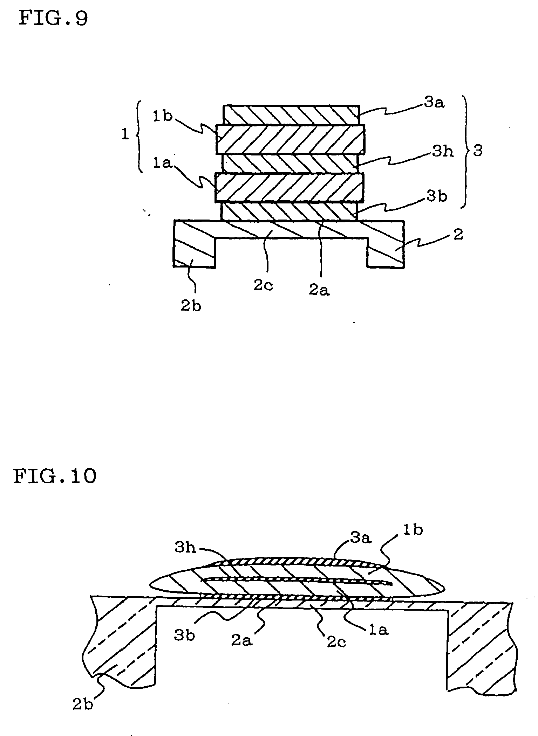

There is not any restriction on the number of the piezoelectric portions or the electrodes constituting the piezoelectric device of the present embodiment. Therefore, a plurality of piezoelectric portions and a plurality of electrodes may be disposed. Therefore, in the present embodiment, as shown in FIGS. 9 and 10, the piezoelectric device preferably has a so-called multilayered structure in which, for example, two piezoelectric portions 1 (1a, 1b) and a plurality of electrodes 3 (upper electrode 3a, lower electrode 3b, and intermediate electrode 3h) are disposed, and two piezoelectric portions 1 (1a, 1b) are alternately sandwiched and laminated between the plurality of electrodes 3 (upper electrode 3a, lower electrode 3b, and intermediate electrode 3h). In such multilayered structure, it is possible to obtain a larger flexural displacement even in a case where a low electric field is applied.

There is not any special restriction on a surface shape (shape of the surface to which the lower electrode 3b is solidly attached in FIG. 1) of the substrate in the piezoelectric device of the present embodiment. Examples of the surface shape include a rectangular shape, a square shape, a triangular shape, an elliptic shape, a circular shape, a curved square shape, a curved rectangular shape, and a composite shape of a combination of these shapes. There is not any special restriction on the whole shape of the substrate, and the substrate may have a capsule shape having an appropriate internal space.

Moreover, as to the shape of the thin portion of the substrate, from a view that linearity of a flexural displacement with respect to the electric field is high, the center of the thin portion preferably has a shape bent on a side opposite to a side on which the piezoelectric portion is disposed, or a sectional shape in a thickness direction has a so-called W-shape. In this shape, opposite end portions of the substrate protrude in a perpendicular direction from a bottom-portion side as seen from a center line in a longitudinal direction of the substrate, and the center of the shape protrudes upwards.

In the present embodiment, the piezoelectric portion 1 (see FIG. 1) constituting the piezoelectric device is constituted of a first piezoelectric porcelain composition containing as a major component a first $Pb(Mg, Ni)_{1/3}Nb_{2/3}O_3$-$PbZrO_3$-$PbTiO_3$ ternary solid solution system composition represented by the following formula (1):

$$Pb_x\{(Mg_{1-y}Ni_y)_{(1/3)}\times_a Nb_{2/3}\}_b Ti_c Zr_d O_3 \ \ldots \ (1),$$

wherein $0.95 \leq x \leq 1.05$, $0.20 < y \leq 0.50$, $0.90 \leq a \leq 1.10$, and b, c, and d are decimals (with the proviso that (b+c+d) = 1.000) in a range surrounded with (b, c, d) = (0.550, 0.425, 0.025), (0.550, 0.325, 0.125), (0.375, 0.325, 0.300), (0.050, 0.425, 0.525), (0.050, 0.525, 0.425), and (0.375, 0.425, 0.200) in a coordinate whose coordinate axes are the b, c, and d.

When the main component of the first piezoelectric porcelain composition constituting the piezoelectric portion 1 is the ternary solid solution system composition represented by the above formula (1), the dense piezoelectric portion having a uniform domain structure can be obtained. Therefore, it is possible to increase the flexural displacement of the piezoelectric device, enhance the linearity of the flexural displacement with respect to the electric field, and enhance the durability on conditions that a larger flexural displacement is caused.

In the above formula (1), when a, b, c, and d are set outside the above-described specific range, there is a tendency to cause deteriorations of the flexural displacement of the resultant piezoelectric device, the linearity of the flexural displacement with respect to the electric field, and the durability. When y (replacement ratio of Mg with Ni) in the formula (1) is 0.20 or less, fluctuations of the flexural displacement tend to increase. On the other hand, when y exceeds 0.50, the flexural displacement in the low electric field tends to degrades. It is to be noted that in the piezoelectric device of the present embodiment, $0.25 < y \leq 0.45$ is preferable, and $0.27 \leq y \leq 0.40$ is more preferable in the formula (1) from a viewpoint that the fluctuations of the flexural displacement be reduced, and the deterioration of the flexural displacement in the low electric field be inhibited.

Moreover, in the piezoelectric device of the present embodiment, Ni derived from the first $Pb(Mg, Ni)_{1/3}Nb_{2/3}O_3$-$PbZrO_3$-$PbTiO_3$ ternary solid solution system composition is preferably uniformly dispersed in the piezoelectric portion 1. More preferably, Ni(NiO) derived from the first $Pb(Mg, Ni)_{1/3}Nb_{2/3}O_3$-$PbZrO_3$-$PbTiO_3$ ternary solid solution system composition is dispersed in the piezoelectric portion 1 with a concentration gradient in which the concentration increases from a side brought into contact with the substrate 2 toward an opposite side (side which is not brought into contact with the substrate 2). When the dispersed state of NiO in the piezoelectric portion 1 is se in his manner, the piezoelectric portion 1 can be densified more even in a case where the piezoelectric portion is solidly attached on the substrate 2 directly or via the electrode 3.

In the piezoelectric device of the present embodiment, Pb in the first $Pb(Mg, Ni)_{1/3}Nb_{2/3}O_3$-$PbZrO_3$-$PbTiO_3$ ternary solid solution system composition is preferably replaced with at least one element selected from the group consisting of Sr, Ca, Ba, and La because the piezoelectric characteristic can be enhanced, and the linearity of the flexural displacement with respect to the electric field can be solidly attached in a higher electric field region. Additionally, when Pb is replaced with a high ratio, there are sometimes caused deterioration of the flexural displacement, increase of the flexural displacement change on a temperature change, and deterioration of the linearity of a flexural displacement amount with respect to an electric field amount. Therefore, a preferable replacement ratio range is preferably set for each replacing element.

To be more specific, when Pb in the first $Pb(Mg, Ni)_{1/3}Nb_{2/3}O_3$-$PbZrO_3$-$PbTiO_3$ ternary solid solution system composition is replaced with at least one element selected from the group consisting of Sr, Ca, and Ba, preferably 2 to 10 mol%, more preferably 4 to 8 mol% of Pb is replaced. When Pb is replaced with La, preferably 0.2 to 1.0 mol%, more preferably 0.4 to 0.9 mol% of Pb is replaced.

Moreover, in the piezoelectric device of the present embodiment, a first piezoelectric porcelain composition constituting the piezoelectric portion is preferably crystal grains whose average grain diameter is 1 to 10 $\mu$m and whose maximum grain diameter is five times or less the average grain diameter. More preferably, the average grain diameter is 2 to 5 $\mu$m, and the maximum grain diameter is four times or less the average grain diameter. Especially preferably, the average grain diameter is 2 to 5 $\mu$m, and the maximum grain diameter is three times or less the average grain diameter. When the average grain diameter of the crystal grains (first piezoelectric porcelain composition) is less than 1 $\mu$m, a domain in the piezoelectric portion does not sufficiently develop, and there are easily caused the deterioration of the flexural displacement, and the deterioration of the linearity of the flexural displacement with respect to the electric field in the high electric field region. On the other hand, when the average grain diameter exceeds 10 $\mu$m, the domain in the piezoelectric portion is large, but the domain does not easily move, and the flexural displacement is easily reduced. When the maximum grain diameter exceeds five times the average grain diameter, coarse grains increase in which the domain does not easily move, and the flexural displacement is easily reduced.

In the piezoelectric device of the present embodiment, at least a part of Ni in the first piezoelectric porcelain composition preferably exists as grains (hereinafter referred to also as "NiO grains") containing NiO as a major component. When such NiO grains exist, the linearity of the flexural displacement with respect to the electric field can be secured in the high electric field region. A large flexural displacement can be obtained with an equal power as compared with a conventional piezoelectric device.

Moreover, in the piezoelectric device of the present invention, NiO grains preferably exist inside the crystal grains (first piezoelectric porcelain composition) or in the surface and the inside of the crystal grains (first piezoelectric porcelain composition) because the linearity of the flexural displacement with respect to the electric field can be secured up to a higher electric field region.

There is not any special restriction on grain diameters of the NiO grains, but they are preferably in a range of 0.1 to 2 $\mu$m. The NiO grains may be made of only NiO, or may be formed by containing MgO as solid solution. However, the NiO grains are preferably formed by containing MgO as solid solution because the linearity of the flexural displacement is large.

In the piezoelectric porcelain composition constituting the piezoelectric portion of the piezoelectric device according to the present embodiment, a content of a phase other than perovskite phase is preferably 20 vol% or less, more preferably 10 vol% or less in order to enhance the flexural displacement of the piezoelectric device. The piezoelectric porcelain composition has a porosity of preferably 10 vol% or less, more preferably 5 vol% or less in order to secure desired flexural displacement and mechanical strength and enhance the linearity of the flexural displacement with respect to the electric field in the high electric field region.

In the piezoelectric device of the present embodiment, the piezoelectric portion 1 (see FIG. 1) has a thickness of preferably 1 to 300 $\mu$m, more preferably 3 to 100 $\mu$m, especially preferably 5 to 30 $\mu$m. When the thickness of the piezoelectric portion 1 is less than 1 $\mu$m, even the piezoelectric portion made of the above-described specific piezoelectric porcelain composition is easily insufficiently densified. On the other hand, when the thickness of the piezoelectric portion exceeds 300 $\mu$m, a stress loaded on the substrate is relatively excessively large, and the substrate needs to be provided with a sufficient thickness from a viewpoint of prevention of breakdown. Therefore, it is sometimes difficult to miniaturize the piezoelectric device itself.

Moreover, in the piezoelectric device of the present embodiment, from a viewpoint that the mechanical strength and the desired flexural displacement be secured, a value of a ratio (thickness of substrate/thickness of piezoelectric portion) of the thickness of the substrate 2 with respect to that of the piezoelectric portion 1 is preferably 0.1 to 30, more preferably 0.3 to 10, especially preferably 0.5 to 5.

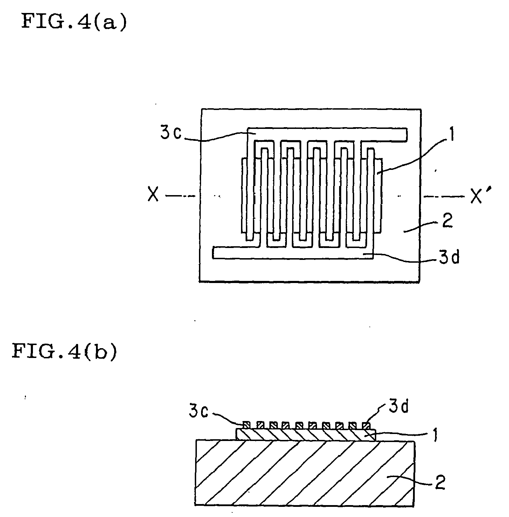

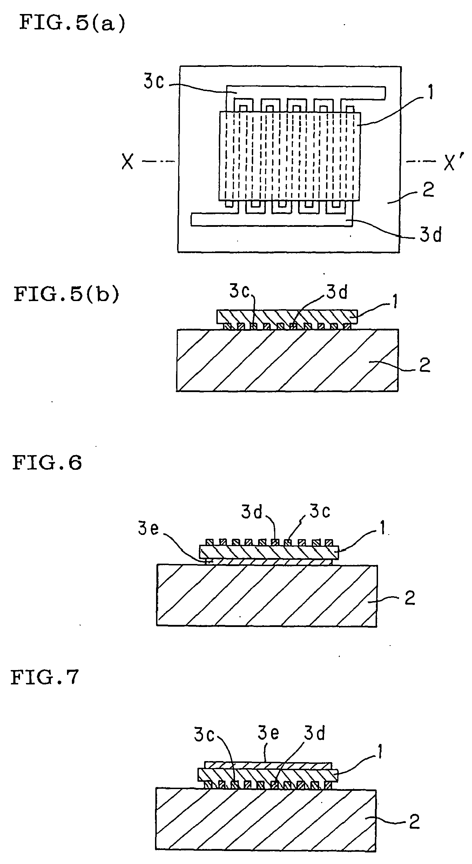

The electrode 3 (upper electrode 3a, lower electrode 3b) constituting the piezoelectric device of the present embodiment may be electrically connected to the piezoelectric portion 1. Examples of a configuration of the electrode 3 include a pair of comb-shaped electrodes 3c, 3d solidly attached in a comb shape onto the piezoelectric portion 1 solidly attached on the substrate 2 as shown in FIG. 4. As shown in FIG. 5, the pair of comb-shaped electrodes 3c, 3d may be solidly attached between the substrate 2 and the piezoelectric portion 1.

It is to be noted that as shown in FIG. 6, the piezoelectric portion 1 may be solidly attached on the pair of comb-shaped electrodes 3c, 3d solidly attached on the substrate 2, and a common electrode 3e may be formed on a surface opposite to the surface on which the comb-shaped electrodes 3c, 3d are solidly attached. On the other hand, as shown in FIG. 7, the piezoelectric portion 1 may be solidly attached on the common electrode 3e solidly attached to the substrate 2, and the pair of comb-shaped electrodes 3c, 3d may be formed on the surface opposite to that to which the common electrode 3e is solidly attached.

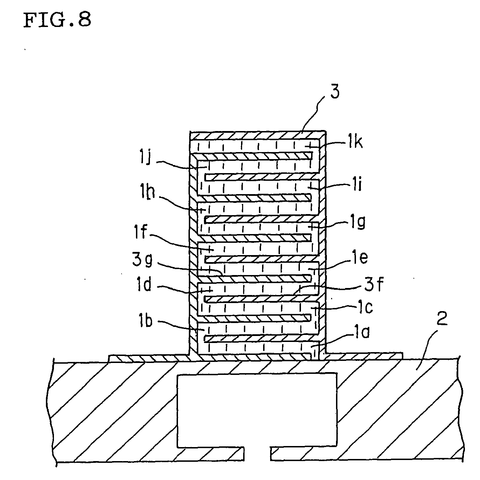

Moreover, as shown in FIG. 8, the piezoelectric device of the present embodiment preferably has a multilayered structure provided with a plurality of piezoelectric portions 1a to 1k, a plurality of anodes 3f, and a plurality of cathodes 3g (electrode 3). The plurality of piezoelectric portions 1a to 1k are alternately sandwiched and laminated between the plurality of anodes 3f and cathodes 3g, and the piezoelectric portion 1a (lowermost piezoelectric portion) positioned in a lowermost layer among the piezoelectric portions 1a to 1k is solidly attached on the substrate 2 directly or via a lowermost electrode (cathode 3g) positioned in the lowermost layer of the electrode 3. According to the multilayered structure, a larger flexural displacement can be obtained even in a case where the low electric field is applied.

A width of the electrode is preferably 60 to 90%, more preferably 70 to 80% of that of the piezoelectric portion. When the width of the electrode is less than 60% of that of the piezoelectric portion, an area of the piezoelectric portion to which the electric field is applied is reduced, and therefore the resultant flexural displacement sometimes becomes small. On the other hand, when the width of the electrode exceeds 90% of that of the piezoelectric portion, high-precision adjustment is required for positioning the electrode. When the positioning precision is low, short-circuit between the electrodes and dielectric breakdown are sometimes caused.

There is not any special restriction on a material of the electrode 3. Typical examples include a material made of at least one kind selected from the group of platinum, palladium, rhodium, gold, silver, and an alloy of them. A glass component may be added to the electrode in order to facilitate film formation during thermal treatment. Above all, it is preferable to use platinum or an alloy containing platinum as a major component because it has a high heat resistance during the thermal treatment of the piezoelectric portion. To constitute the above-described laminated piezoelectric device (see FIG. 8), as to the materials of the electrodes 3, all of the electrodes 3 may be constituted of the same material, or the materials of a part or all of the electrodes 3 may differ.

When the electrode 3 (see FIG. 1(a)) is excessively thick, the electrode 3 functions as a relaxing layer, and the flexural displacement easily becomes small. Therefore, the thickness of the electrode 3 is preferably 15 $\mu$m or less, more preferably 5 $\mu$m or less.

In the piezoelectric device of the present embodiment, the electrode 3 is electrically connected to the piezoelectric portion 1. The piezoelectric portion 1 is solidly attached to the substrate 2 directly or via the electrode 3. That is, since any adhesive is not used, it is possible to avoid the deterioration of a vibration transmitting property between the substrate 2 and the piezoelectric portion 1 owing to the presence of the adhesive or the like, and the deterioration of the piezoelectric characteristic due to the characteristic deterioration of the piezoelectric portion 1 or substrate 2 by permeation of an adhesive component or the like. It is to be noted that "solidly attached" mentioned in the present specification indicates a closely integrated state of both of the substrate 2 and the piezoelectric portion 1 or the electrode 3 due to a solid phase reaction of both of them without using any organic or inorganic adhesive. It is to be noted that in the laminated piezoelectric device, as shown in FIG. 8, the piezoelectric portion 1a positioned in a lowermost portion may be solidly attached on the substrate 2 via the electrode 3 (cathode 3g), or directly solidly attached without interposing any electrode.

Moreover, in the piezoelectric device of the present embodiment, a ratio of capacity after polarization with respect to that before the polarization is preferably 120% or more, more preferably 125% or more because of a structure in which the domain easily moves.

Next, there will be described a method of manufacturing the piezoelectric device of the present embodiment. To manufacture the piezoelectric device of the present embodiment, first the piezoelectric material (piezoelectric porcelain composition) containing the specific ternary solid solution system composition as a major component is laminated on the substrate made of a ceramic or on the electrode formed on this substrate. It is to be noted that the substrate can be prepared by obtaining a molded body having a desired shape by means of a working method such as press working or extrusion working using a ceramic material, and sintering the resultant molded body on usually performed conditions.

The piezoelectric material (first piezoelectric porcelain composition) contains as a major component the first Pb (Mg, Ni)$_{1/3}$Nb$_{2/3}$O$_3$-PbZrO$_3$-PbTiO$_3$, ternary solid solution system composition represented by a predetermined formula, and can be prepared as follows.

First, a single article constituted of an element such as Pb, Ba, Ca, Sr, La, Mg, Ni, Nb, Zr, or Ti, an oxide of each element (e.g., PbO, Pb$_3$O$_4$, La$_2$O$_3$, MgO, NiO, Nb$_2$O$_5$, Ti0$_2$, ZrO$_2$), carbonate of each element (e.g., BaCO$_3$, SrCO$_3$, MgCO$_3$, CaCO$_3$), a compound containing a plurality of elements (e.g., MgNb$_2$O) and the like are mixed in such a manner that a content ratio of elements such as Pb, Ba, Ca, Sr, La, Mg, Ni, Nb, Zr, and Ti is a desired ratio shown by the formula (1), and a mixture is prepared. The average particle diameter of the mixture is preferably set to 1 $\mu$m or less because uniform mixing is possible. The diameter is more preferably set to 0.5 $\mu$m or less. When the resultant mixture is calcined at 750 to 1300°C, the first piezoelectric porcelain composition can be obtained.

It is to be noted that to manufacture the piezoelectric device of the present embodiment, a piezoelectric portion is preferably formed by successively laminating and sintering a second piezoelectric porcelain composition containing as a major component a second $Pb(Mg, Ni)_{1/3}Nb_{2/3}O_3$-$PbZrO_3$-$PbTiO_3$ ternary solid solution system composition represented by the following formula (2), and a third piezoelectric porcelain composition containing as a major component a $PbMg_{1/3}Nb_{2/3}O_3$-$PbZrO_3$-$PbTiO_3$ ternary solid solution system composition represented by the following formula (3) and 0.1 to 3.0% by mass of NiO. Consequently, it is possible to form the piezoelectric portion having a desired composition without causing any deviation.

$$Pb_x\{(Mg_{1-y}Ni_y)_{(1/3)}x_aNb_{2/3}\}_bTi_cZr_dO_3 \ldots (2),$$

wherein $0.95 \le x \le 1.05$, $0.05 \le y \le 0.20$, $0.90 \le a \le 1.10$, and b, c, and d are decimals (with the proviso that (b+c+d) = 1.000) in a range surrounded with (b, c, d) = (0.550, 0.425, 0.025), (0.550, 0.325, 0.125), (0.375, 0.325, 0.300), (0.050, 0.425, 0.525), (0.050, 0.525, 0.425), and (0.375, 0.425, 0.200) in a coordinate whose coordinate axes are the b, c, and d.

$$Pb_x(Mg_{y/3}Nb_{2/3})_aTi_bZr_dO_3 \ldots (3),$$

wherein $0.95 \le x \le 1.05$, $0.95 \le y \le 1.05$, and a, b, and c are decimals (with the proviso that a+b+c = 1.00) in a range surrounded with (a, b, c) = (0.550, 0.425, 0.025), (0.550, 0.325, 0.125), (0.375, 0.325, 0.300), (0.050, 0.425, 0.525), (0.050, 0.525, 0.425), and (0.375, 0.425, 0.200) in a coordinate whose coordinate axes are the a, b, and c.

As to the piezoelectric porcelain composition, a ratio of a strength of a strongest diffraction line of a perovskite phase with respect to that of a strongest diffraction line of a pyrochlore phase is preferably 5% or less, more preferably 2% or less in a diffraction strength by an X-ray diffraction device.

When the piezoelectric porcelain composition is grinded using a grinding device such as a ball mill, an attritor, or a beads mill, it is possible to obtain a piezoelectric material powder having desired particle diameters. An average particle diameter of the piezoelectric material powder is preferably 0.1 to 1.0 $\mu$m, more preferably 0.3 to 0.7 $\mu$m. A maximum particle diameter of the piezoelectric material powder is preferably 3.0 $\mu$m or less, more preferably 2.0 $\mu$m or less. When the particle diameter of the piezoelectric material powder is set in this manner, it is possible to obtain a piezoelectric porcelain composition having an average grain diameter of 1 to 10 $\mu$m, and a maximum grain diameter of five times or less the average grain diameter by a thermal treatment described later.

It is to be noted that the particle diameter of the piezoelectric material powder may be adjusted by thermally treating a grinded material at 400 to 750°C. Accordingly, finer particles are preferably integrated with the other particles to constitute the powder having a uniform particle diameter, and it is preferably possible to form the piezoelectric portion having the uniform grain diameter. The piezoelectric material may be prepared by, for example, an alkoxide process, a coprecipitation process or the like.

Examples of a method of laminating the piezoelectric material on the substrate or the like include a screen printing process, a spraying process, and a dipping process. Above all, the screen printing process is preferable in that it is possible to easily laminate the materials continuously into a high-precision shape and thickness. To solidly attach the piezoelectric portion directly on the substrate, the piezoelectric material may be laminated directly on the substrate. On the other hand, to solidly attach the piezoelectric portion on the substrate via the electrode, first the electrode is formed on the substrate, and the piezoelectric material may be laminated on the electrode. Examples of a method of forming the electrode include ion beam, sputtering, vacuum evaporation, PVD, ion plating, CVD, plating, screen printing, spraying, and dipping. Above all, the sputtering method or the screen printing method is preferable in respect of a bonding property to the substrate or the piezoelectric portion.

The resultant electrode can be formed integrally with the substrate and/or the piezoelectric portion by a thermal treatment at about 1000 to 1400°C. This thermal treatment may be performed before laminating the piezoelectric material, that is, at a time when the electrode is formed, but the thermal treatment may be performed together with a thermal treatment performed after laminating the piezoelectric material as described later.

Next, the piezoelectric material laminated on the substrate or the electrode is allowed to exist together with an atmosphere control material having the same composition as that of the piezoelectric material, and thermally treated in a sealed atmosphere. Accordingly, element components such as Pb and Ni are prevented from being suvlimated, and the piezoelectric portion can be formed which contains the respective element components at a desired ratio. According to this thermal treatment, the piezoelectric portion can be solidly attached to the substrate directly or via the electrode.

During the thermal treatment, the atmosphere control material coexists by preferably 0.03 to 0.50 mg/cm$^3$, more preferably 0.07 to 0.40 mg/cm$^3$, especially preferably 0.10 to 0.30 mg/cm$^3$ in terms of an amount of NiO per space unit volume in a container in the atmosphere. When the NiO converted amount of the coexisting atmosphere control material per in-container space unit volume in the atmosphere is less than 0.03 mg/cm$^3$, the piezoelectric portion containing a desired amount of Ni is not easily formed. Therefore, the piezoelectric device is sometimes constituted in which the linearity of the flexural displacement with respect to the electric field is low in a case where a high electric field is applied. On the other hand, when the NiO converted amount of the coexisting atmosphere control material per in-container space unit volume in the atmosphere exceeds 0.50 mg/cm$^3$, the piezoelectric device is sometimes formed in which NiO grains excessively exist, and there is a tendency to easily cause the dielectric breakdown.

It is to be noted that when the NiO converted amount of the coexisting atmosphere control material per in-container space unit volume in the atmosphere is set to be same to that of the piezoelectric porcelain composition constituting the piezoelectric material, NiO can be uniformly dispersed in the piezoelectric portion. When a concentration of NiO is set to be higher than that of the piezoelectric porcelain composition constituting the piezoelectric material, NiO can be dispersed in the piezoelectric portion with a concentration gradient in which the concentration increases from a side brought into contact with the substrate toward an opposite side (side which is not brought into contact with the substrate). When the NiO content of the coexisting atmosphere control material is adjusted, the concentration gradient can be adjusted.

During the thermal treatment, it is preferable to use a container or a shelf plate subjected to the thermal treatment (hereinafter referred to simply as "preliminary treatment") in the atmosphere in which the piezoelectric material coexists with the atmosphere control material having the same composition as a container or a shelf plate in or on which the substrate with the piezoelectric material laminated thereon is stored or laid. When such container or the shelf plate is used, it is possible to form the piezoelectric portion securely containing a desired amount of NiO, and it is possible to manufacture the piezoelectric device in which the linearity of the flexural displacement with respect to the electric field is high up to the high electric field region.

Moreover, during the thermal treatment, the piezoelectric material is more preferably thermally treated using the container and the shelf plate subjected to the preliminary treatment in addition to the coexistence of the predetermined amount of the atmosphere control material. Consequently, it is possible to form the piezoelectric portion in which NiO grains exist in the surface or inside of the crystal grain (first piezoelectric porcelain composition), and it is possible to manufacture the piezoelectric device in which the linearity of the flexural displacement with respect to the electric field is higher up to the high electric field region. It is to be noted that in order to unevenly distribute the NiO grains, the thermal treatment may be performed on conditions that the NiO grains can be formed in the same manner as in a case where "NiO is dispersed in the piezoelectric portion with the above-described concentration gradient in which the concentration increases from the side brought into contact with the substrate toward the opposite side (side that is not brought into contact with the substrate".

A material of each of the container and the shelf plate preferably contains as a major component magnesium oxide, aluminum oxide, zirconium oxide, mullite or spinel. In order to exhibit effects due to the preliminary treatment sufficiently, the preliminary treatment is preferably performed at a temperature at which the piezoelectric material laminated on the substrate or the like is thermally treated $\pm 100°C$. The preliminary treatment is performed preferably a plurality of times, more preferably three times or more in order that the NiO grains securely exist in the surfaces or the insides of the crystal grains. It is also preferable to thermally treat the piezoelectric material a plurality of times after performing the preliminary treatment once. Moreover, it is preferable to thermally treat the piezoelectric material once after performing the preliminary treatment a plurality of times. Furthermore, it is preferable to thermally treat the piezoelectric material a plurality of times after performing the preliminary treatment a plurality of times.

A thermal treatment temperature of the piezoelectric material is preferably 1000 to 1400°C, more preferably 1100 to 1350°C. When the temperature is less than 1000°C, the substrate is insufficiently solidly attached to the piezoelectric portion, or denseness of the piezoelectric portion becomes insufficient in some case. On the other hand, when the temperature exceeds 1400°C, a sublimated amount of Pb or Ni in the piezoelectric material increases, and it is sometimes difficult to constitute the piezoelectric portion having a desired composition.

Moreover, a time to retain a maximum temperature of the thermal treatment is set to preferably ten minutes to ten hours, more preferably 1 to 4 hours. When the time is less than ten minutes, densification or grain growth of the piezoelectric portion easily becomes insufficient, and desired characteristics cannot be obtained in some case. On the other hand, in a case where the time exceeds ten hours, even when the atmosphere is controlled, the sublimated amount of Pb or Ni increases, the characteristics are deteriorated, and the dielectric breakdown easily occurs in some case.

The thermal treatment of the piezoelectric material may be performed before forming the electrode, but may be performed together with the thermal treatment of the electrode after forming the electrode. Similarly, as to the laminated piezoelectric device (see FIG. 8), a layer formed of each electrode and each piezoelectric material may be thermally treated every time each layer is formed, or all of the layers may be thermally treated after they are formed. A cycle may be repeated to perform the thermal treatment after several layers constituted of the electrodes and the piezoelectric materials are formed.

Moreover, after the thermal treatment, an electric field over a coercive electric field of the piezoelectric portion is applied, and a polarization treatment is preferably performed to set a polarization direction to be uniform. A capacity after the polarization treatment is preferably 120% or more, more preferably 125% or more of a capacity before the polarization treatment.


[Examples]

The present invention will be specifically described hereinafter based on examples, but the present invention is not limited to these examples. There will be described hereinafter methods of measuring and evaluating various physical values and characteristics.

[Flexural Displacement]: A flexural displacement generated when applying a voltage between upper and lower electrodes in such a manner as to obtain an electric field of 1.5 kV/mm was measured with a laser displacement measurement unit. The flexural displacement of each of 100 piezoelectric devices according to examples and comparative examples was measured, and an average value was obtained as the flexural displacement ($\mu$m).

[4/2 Flexural Displacement Ratio]: A ratio (4/2 flexural displacement ratio (%)) of flexural displacements generated when applying a voltage to obtain an electric field of 4 kV/mm was measured and calculated with respect to a flexural displacement generated when applying a voltage between upper and lower electrodes in such a manner as to obtain an electric field of 2 kV/mm. It is to be noted that when linearity of the flexural displacement with respect to the electric field becomes higher, the 4/2 flexural displacement ratio indicates a value more approximate to 200%.

[Flexural Displacement Fluctuation] A flexural displacement of each of 100 piezoelectric devices according to examples and comparative examples was measured, and a value obtained by dividing 3$\sigma$ by an average value was calculated as "flexural displacement fluctuation (%)".

[Average Grain Diameter and Maximum Grain Diameter]: The surfaces of crystal grains constituting a piezoelectric portion were microscopically inspected with a scanning electron microscope. Specifically, a straight line was drawn in an arbitrary observed image, a grain boundary distance crossing the straight line was obtained as a grain diameter, and the grain diameters of 100 crystal grains were measured to calculate an average grain diameter and a maximum grain diameter.

[Porosity]: A region having a vertical size of 50 $\mu$m $\times$ a lateral size of 50 $\mu$m in the surface of a piezoelectric portion of a piezoelectric device was microscopically inspected with a scanning electron microscope, area ratios occupied by pores in the piezoelectric portion in three view fields were obtained, and an average value of the area ratios was calculated as "porosity (%)".


(Example 1)

On a $ZrO_2$ substrate (dimension of a thin portion: 1.6$\times$1.1 mm, thickness: 100 $\mu$m, a sectional shape in a thickness direction was rectangular (the surface to which a piezoelectric portion or an electrode was flat)) stabilized by $Y_2O_3$, and a lower electrode (dimension: 1.2x0.8 mm, thickness: 3 $\mu$m) made of platinum was formed by a screen printing process, and formed integrally with the substrate by a thermal treatment at 1300°C for two hours. On this electrode, a piezoelectric material having an average particle diameter of 0.45 $\mu$m and a maximum particle diameter of 1.8 $\mu$m, and constituted of a ternary solid solution system composition (piezoelectric porcelain composition) represented by $Pb_{1.0}\{(Mg_{0.87}Ni_{0.13})_{1/3}Nb_{2/3}\}_{0.20}Ti_{0.43}Zr_{0.37}O_3$ was laminated with a dimension: 1.3$\times$0.9 mm and a thickness of 11 $\mu$m by the screen printing process. There were further successively laminated: an electrode (dimension: 1.0$\times$0.6 mm, thickness: 3 $\mu$m); and a piezoelectric material constituted of a piezoelectric porcelain composition having an average particle diameter of 0.52 $\mu$m and a maximum particle diameter of 2.0 $\mu$m, and containing 98.5% by mass of a ternary solid solution system composition represented by $Pb_{1.00}\{(Mg_{1/3}Ni_{2/3})_{0.20}Ti_{0.43}Zr_{0.37}O_3$ and 1.5% by mass of NiO. They were laminated by the screen printing process to obtain a dimension: 1.3x0.9 mm and a thickness: 11 $\mu$m.

Next, the piezoelectric material and the electrode laminated on the substrate were thermally treated at 1275°C for two hours in a container in which an upper-layer piezoelectric material and an atmosphere control material having the same composition coexisted by 0.15 mg/cm$^3$ (NiO amount included per in-container space unit volume in the atmosphere control material having the same composition as that of the piezoelectric material). The piezoelectric portion subjected to the thermal treatment had a thickness of 10 $\mu$m.

It is to be noted that before the thermal treatment, a preliminary treatment was performed once in a container in which the upper-layer piezoelectric material and the atmosphere control material having the same composition coexisted by 0.15 mg/cm$^3$ (NiO amount included per in-container space unit volume in the atmosphere control material having the same composition as that of the piezoelectric material), and the container and a shelf plate accustomed to the atmosphere were used. Subsequently, after forming an upper electrode (dimension: 1.2$\times$0.8 mm, thickness: 0.5 $\mu$m)

made of gold on the upper-layer piezoelectric portion by the screen printing process, the thermal treatment was performed to manufacture a piezoelectric device.

(Example 2)

A piezoelectric device was manufactured in the same manner as in Example 1 described above except that there were used: a piezoelectric material having an average particle diameter of 0.51 $\mu$m and a maximum particle diameter of 5.3 $\mu$m, and constituted of a ternary solid solution system composition (piezoelectric porcelain composition) represented by $Pb_{1.00}$ { $(Mg_{0.870}Ni_{0.130})_{1/3}Nb_{2/3}\}_{0.20}Ti_{0.43}Zr_{0.37}O_3$; and a piezoelectric material constituted of a piezoelectric porcelain composition having an average particle diameter of 0.49 $\mu$m, a maximum particle diameter of 4.7 $\mu$m and containing 98.5% by mass of a ternary solid solution system composition represented by $Pb_{1.00}$ $(Mg_{1/3}Ni_{2/3})_{0.20}Ti_{0.43}Zr_{0.37}O_3$ and 1.5% by mass of NiO.

(Evaluation)

Crystal grains constituting the piezoelectric portion of the piezoelectric device of Example 1 had an average grain diameter of 2.8 $\mu$m and a maximum grain diameter of 6.9 $\mu$m. A 4/2 flexural displacement ratio was 167%, and it has been found that linearity of the flexural displacement with respect to an electric field is high. The flexural displacement was as large as 1.43 $\mu$m. It is to be noted that to check the composition of the piezoelectric portion of the piezoelectric device of Example 1, the piezoelectric portion was polished, and analyzed by EPMA. As a result, the composition of the piezoelectric portion of a lower layer was the same as that of the piezoelectric portion of an upper layer, that is, "$Pb_{0.99}$ $\{(Mg_{0.70}Ni_{0.30})_{1/3}Nb_{2/3}\}_{0.20}Ti_{0.42}Zr_{0.38}O_3$" .

On the other hand, crystal grains constituting the piezoelectric portion of the piezoelectric device of Example 3 had an average grain diameter of 2.9 $\mu$m and a maximum grain diameter exceeded five times (14.8 $\mu$m) the average grain diameter. Moreover, a 4/2 flexural displacement ratio of this piezoelectric device was 150%. It has been found that the linearity of the flexural displacement with respect to the electric field is lower than that of the piezoelectric device of Example 1. The flexural displacement was 1.21 $\mu$m, and smaller than that of the piezoelectric device of Example 1. It is to be noted that the composition of the piezoelectric portion of the lower layer was the same as that of the piezoelectric portion of the upper layer, that is, "$Pb_{0.99}$ $\{(Mg_{0.70}Ni_{0.30})_{1/3}Nb_{2/3}\}_{0.20}Ti_{0.42}Zr_{0.38}O_3$" . Results are collectively shown in Table 1.

[Table 1]

|  | Average grain diameter ($\mu$m) | Maximum grain diameter ($\mu$m) | Maximum/ average grain diameter | 4/2 flexural displacement ratio (%) | Flexural displacement ($\mu$m) | Flexural displacement fluctuation (%) |
|---|---|---|---|---|---|---|
| Ex.1 | 2.8 | 6.9 | 2.5 | 167 | 1.43 | 2.2 |
| Ex.2 | 2.9 | 14.8 | 5.1 | 150 | 1.21 | 2.7 |

(Reference Examples 1 to 3)

Piezoelectric devices were manufactured in the same manner as in Example 1 described above except that there was prepared a piezoelectric porcelain composition containing: 98.5% by mass of a ternary solid solution system composition (piezoelectric porcelain composition) represented by $Pb_{1.00}\{(Mg_{0.70}Ni_{0.30})_{1/3}Nb_{2/3}\}_{0.20}Ti_{0.43}Zr_{0.37}O_3$ and a ternary solid solution system composition represented by $Pb_{1.00}(Mg_{1/3}Nb_{2/3})_{0.20}Ti_{0.43}Zr_{0.37}O_3$; and 1.5% by mass of NiO, and there were used piezoelectric materials obtained by mixing 3 vol%, 7 vol%, and 15 vol% of latex having particle diameters of 8 to 12 $\mu$m with 97 vol%, 93 vol%, and 85 vol% of the piezoelectric porcelain composition, respectively.

(Evaluation)

The piezoelectric portion of the piezoelectric device (containing 15 vol% of latex in the piezoelectric material) of Reference Example 3 had a porosity of 17%, a 4/2 flexural displacement ratio of 140%, and a flexural displacement of 1.08 $\mu$m. The piezoelectric portion of the piezoelectric device (containing 7 vol% of latex in the piezoelectric material) of Reference Example 2 had a porosity of 9%, a 4/2 flexural displacement ratio of 151%, and a flexural displacement of 1.27 $\mu$m. The piezoelectric portion of the piezoelectric device (containing 3 vol% of latex in the piezoelectric material) of Reference Example 1 had a porosity of 5%, a 4/2 flexural displacement ratio of 165%, and a flexural displacement of

1.33 $\mu$m. It has been confirmed from the above that when the porosity of the piezoelectric portion decreases, the linearity of the flexural displacement with respect to the electric field becomes high, and the flexural displacement enlarges. Results are collectively shown in Table 2.

[Table 2]

|  | Latex amount (vol%) | Porosity (%) | 4/2 flexural displacement ratio (%) | flexural displacement ($\mu$m) |
|---|---|---|---|---|
| Reference Example 1 | 3 | 5 | 165 | 1.33 |
| Reference Example 2 | 7 | 9 | 151 | 1.27 |
| Reference Example 3 | 15 | 17 | 140 | 1.08 |

(Comparative Examples 1, 2)

Piezoelectric devices were manufactured in the same manner as in Example 1 described above except that a piezoelectric materials constituted of different ternary solid solution system compositions were used so as to obtain a composition of the resultant piezoelectric portion as shown in Table 3.

A porosity of a piezoelectric portion (replacement ratio of Mg with Ni was 0.30) of a piezoelectric device of Example 1 was as small as 2%. The flexural displacement was as large as 1.43 $\mu$m, and a flexural displacement fluctuation was as small as 2.2%. On the other hand, the porosity of the piezoelectric portion (replacement ratio of Mg with Ni was 0.18) of the piezoelectric device of Comparative Example 1 was 3%. The flexural displacement was as large as 1.29 $\mu$m, but the flexural displacement fluctuation was as large as 3.3%. The result was inferior to that of the piezoelectric device of Example 1.

On the other hand, the porosity of the piezoelectric portion (replacement ratio of Mg with Ni was 0.55) of the piezoelectric device of Comparative Example 2 was as small as 4%. The flexural displacement fluctuation was 2.9%, and comparatively small. However, the flexural displacement was 1.19 $\mu$m, and smallest. Results are collectively shown in Table 3.

[Table 3]

|  | Piezoelectric portion | Porosity (%) | Flexural displacement ($\mu$m) | Flexural displacement fluctuation (%) |
|---|---|---|---|---|
| Ex. 1 | $Pb_{0.99}\{(Mg_{0.70}Ni_{0.30})_{1/3}Nb_{2/3}\}_{0.20}Ti_{0.42}Zr_{0.38}O_3$ | 2 | 1.43 | 2.2 |
| CE1 | $Pb_{1.00}\{(Mg_{0.82}Ni_{0.18})_{1/3}Nb_{2/3}\}_{0.20}Ti_{0.43}Zr_{0.37}O_3$ | 3 | 1.39 | 3.3 |
| CE2 | $Pb_{1.00}\{(Mg_{0.45}Ni_{0.55})_{1/3}Nb_{2/3}\}_{0.20}Ti_{0.43}Zr_{0.37}O_3$ | 4 | 1.19 | 2.9 |

(Example 3)

A piezoelectric device was manufactured in the same manner as in Example 1 described above except that there were successively laminated: a piezoelectric material constituted of a ternary solid solution system composition (piezoelectric porcelain composition) represented by $Pb_{1.00}\{(Mg_{0.84}Ni_{0.16})_{0.97/3}Nb_{2/3}\}_{0.20}Ti_{0.437}Zr_{0.37}O_3$; a platinum electrode; and a piezoelectric material constituted of a piezoelectric porcelain composition containing 99.4% by mass of a ternary solid solution system composition represented by $Pb_{1.00}(Mg_{1/3}Ni_{2/3})_{0.20}Ti_{0.43}Zr_{0.37}O_3$ and 0.6% by mass of NiO. The composition of a piezoelectric portion of the resultant piezoelectric device was uniformly $Pb_{1.00}\{(Mg_{0.77}Ni_{0.23})_{0.97/3}Nb_{2/3}\}_{0.20}Ti_{0.43}Zr_{0.37}O_3$.

(Example 4)

A piezoelectric device was manufactured in the same manner as in Example 1 described above except that there were successively laminated, on an electrode formed integrally with a $ZrO_2$ substrate, a piezoelectric material constituted of a ternary solid solution system composition (piezoelectric porcelain composition) represented by $Pb_{1.00}\{(Mg_{0.84}Ni_{0.16})_{0.97/3}Nb_{2/3}\}_{0.20}Ti_{0.43}Zr_{0.37}O_3$; a platinum electrode; and a piezoelectric material constituted of a piezoelectric porcelain composition containing 99.0% by mass of a ternary solid solution system composition represented by $Pb_{1.00}\{(Mg_{0.84}Ni_{0.16})_{0.97/3}Nb_{2/3}\}_{0.20}T1_{0.43}Zr_{0.37}O_3$ and 1.0% by mass of NiO. The composition of a piezoelectric portion of the resultant piezoelectric device was uniformly $Pb_{1.00}\{(Mg_{0.67}Ni_{0.33})_{0.98/3}Nb_{2/3}\}_{0.20}Ti_{0.43}Zr_{0.37}O_3$.

(Example 5)

A piezoelectric device was manufactured in the same manner as in Example 1 described above except that there were successively laminated, on an electrode formed integrally with a $ZrO_2$ substrate, a piezoelectric material constituted of a ternary solid solution system composition (piezoelectric porcelain composition) represented by $Pb_{1.00}\{(Mg_{0.84}Ni_{0.16})_{0.97/3}Nb_{2/3}\}_{0.20}Ti_{0.43}Zr_{0.37}O_3$; a platinum electrode; and a piezoelectric material constituted of a piezoelectric porcelain composition containing 99.0% by mass of a ternary solid solution system composition represented by $Pb_{1.00}\{(Mg_{0.84}Ni_{0.16})_{0.97/3}Nb_{2/3}\}_{0.20}Ti_{0.43}Zr_{0.37}O_3$ and 1.0% by mass of NiO, and a container and a shelf plate subjected to preliminary treatments three times were used during a thermal treatment. The composition of a piezoelectric portion of the resultant piezoelectric device was uniformly $Pb_{1.00}\{(Mg_{0.61}Ni_{0.33})_{1/3}Nb_{2/3}\}_{0.20}Ti_{0.43}Zr_{0.37}O_3$.

(Evaluation)

A 4/2 flexural displacement ratio of the piezoelectric device of Example 3 was 164%, linearity of a flexural displacement with respect to an electric field was comparatively high, and a flexural displacement was as large as 1.45 $\mu$m. When a dispersed state of Ni in the piezoelectric portion was confirmed by EPMA analysis, presence of NiO grains was not recognized.

On the other hand, the piezoelectric device of Example 4 had a 4/2 flexural displacement ratio of 170%, and it was found that the flexural displacement was approximately equal to that of the piezoelectric device of Example 3, and the linearity of the flexural displacement with respect to the electric field was high. When the dispersed state of Ni in the piezoelectric portion was confirmed by the EPMA analysis, the presence of NiO grains was not recognized in the surface of the piezoelectric portion, but the presence of the NiO grains was recognized inside the piezoelectric portion. It was found that Ni was dispersed with a concentration gradient in which the concentration increased from a side brought into contact with the substrate toward an opposite side.

Moreover, the 4/2 flexural displacement ratio of the piezoelectric device of Example 5 was 177%, the flexural displacement was approximately equal to that of the piezoelectric device of Example 3, but the linearity of the flexural displacement with respect to the electric field was highest. When the dispersed state of Ni in the piezoelectric portion was confirmed by the EPMA analysis, the presence of the NiO grains was recognized in the surface and inside of the piezoelectric portion. Furthermore, Mg was detected from the NiO grains. Results are collectively shown in Table 4.

[Table 4]

|  | Presence of NiO grains | Presence of Mg in NiO grains | 4/2 flexural displacement ratio (%) | Flexural displacement ($\mu$m) | Flexural displacement fluctuation (%) |
|---|---|---|---|---|---|
| Ex.3 | None | None | 164 | 1.45 | 2.3 |
| Ex.4 | Present in the inside | None | 170 | 1.42 | 2.6 |
| Ex.5 | Present in the inside and the surface | Detected | 177 | 1.44 | 2.6 |

(Example 6, Comparative Examples 3, 4)

Piezoelectric devices were manufactured in the same manner as in Example 1 described above except that piezoelectric materials were used so as to obtain compositions of the resultant piezoelectric portions as shown in Table 5. It is to be noted that the composition of the resultant piezoelectric portion was uniform.

(Evaluation)

In the piezoelectric device of Example 6 in which a total content ratio of Mg and Ni in the piezoelectric portion was within a range (a = 0.97) of the present invention, a flexural displacement was as large as 1.48 $\mu$m, and a flexural displacement fluctuation was as small as 2.2%. On the other hand, in the piezoelectric device of Comparative Example 3 in which the total content ratio of Mg and Ni in the piezoelectric portion was small (y = 0.86), a flexural displacement was as small as 1.15 $\mu$m, and a flexural displacement fluctuation was as large as 3.4%. In the piezoelectric device of Comparative Example 4 in which the total content ratio of Mg and Ni in the piezoelectric portion was large (y = 1.13), the flexural displacement was 1.04 $\mu$m and smallest, and the flexural displacement fluctuation was as large as 4.0%. Results are collectively shown in Table 5.

[Table 5]

| | Piezoelectric portion | Flexural displacement ($\mu$m) | Flexural displacement fluctuation (%) |
|---|---|---|---|
| Ex. 6 | $Pb_{0.950}Ba_{0.041}La_{0.008}$ $\{(Mg_{0.69}Ni_{0.31})_{0.97/3}Nb_{2/3}\}_{0.20}Ti_{0.42}Zr_{0.38}O_3$ | 1.48 | 2.2 |
| CE3 | $Pb_{0.952}Ba_{0.041}La_{0.008}$ $\{(Mg_{0.70}Ni_{0.30})_{0.86/3}Nb_{2/3}\}_{0.20}Ti_{0.43}Zr_{0.37}O_3$ | 1.15 | 3.4 |
| CE4 | $Pb_{0.950}Ba_{0.040}La_{0.008}$ $(Mg_{0.70}Ni_{0.30})_{1.13/3}Nb_{2/3})_{0.20}Ti_{0.42}Zr_{0.38}O_3$ | 1.04 | 4 |

(Example 7, Comparative Example 5)

Piezoelectric devices were manufactured in the same manner as in Example 1 described above except that piezoelectric materials were used so as to obtain compositions of the resultant piezoelectric portions as shown in Table 6. It is to be noted that the composition of the resultant piezoelectric portion was uniform.

(Evaluation)

In the piezoelectric device of Example 7 in which a content ratio of Pb in the piezoelectric portion was within a range (x = 1.01) of the present invention, a flexural displacement was as large as 1.34 $\mu$m, and a flexural displacement fluctuation was as small as 2.6%. On the other hand, in the piezoelectric device of Comparative Example 5 in which the content ratio of Pb in the piezoelectric portion was small (x = 0.93), a flexural displacement was as small as 1.13 $\mu$m. Results are collectively shown in Table 6.

[Table 6]

| | Piezoelectric portion | Flexural displacement ($\mu$m) | Flexural displacement fluctuation (%) |
|---|---|---|---|
| Ex.7 | $Pb_{1.01}$ $\{(Mg_{0.55}Ni_{0.45})_{1/3}Nb_{2/3}\}_{0.20}Ti_{0.43}Zr_{0.37}O_3$ | 1.34 | 2.6 |
| CE5 | $Pb_{0.93}$ $\{(Mg_{0.55}Ni_{0.45})_{1/3}Nb_{2/3}\}_{0.20}Ti_{0.43}Zr_{0.37}O_3$ | 1.13 | 3.4 |

(Examples 8 to 11)

Piezoelectric devices were manufactured in the same manner as in Example 1 described above except that piezoelectric materials were used so as to obtain compositions of the resultant piezoelectric portions as shown in Table 7. It is to be noted that the composition of the resultant piezoelectric portion was uniform.

(Evaluation)

In each of the piezoelectric devices of Examples 8 to 11, a flexural displacement fluctuation was 0.036 $\mu$m or

less, and comparatively small, and a flexural displacement was 1.44 $\mu$m or larger. However, in the piezoelectric device of Example 9 provided with a piezoelectric portion in which 5.0 mol% of Pb was replaced with Sr, and the piezoelectric device of Example 10 provided with a piezoelectric portion in which 10.0 mol% of Pb was replaced with Ba, the flexural displacements were 1.53 $\mu$m and 1.51 $\mu$m, respectively. They were large as compared with the piezoelectric device of Example 8 provided with the piezoelectric portion in which Pb was not replaced.

On the other hand, in the piezoelectric device of Example 11 provided with the piezoelectric portion in which 7.5 mol% of Pb was replaced with Ba and 7.5 mol% of Pb was replaced with Ca (15 mol% in total), the flexural displacement was 1.44 $\mu$m. It was small as compared with the piezoelectric device of Example 8 provided with the piezoelectric portion in which Pb was not replaced at all. Results are collectively shown in Table 7.

[Table 7]

| | Piezoelectric portion | Flexural displacement ($\mu$m) | Flexural displacement fluctuation (%) |
|---|---|---|---|
| Ex.8 | $Pb_{1.01}\{(Mg_{0.70}Ni_{0.30})_{1/3}Nb_{2/3}\}_{0.12}Ti_{0.45}Zr_{0.43}O_3$ | 1.48 | 2.2 |
| Ex.9 | $Pb_{0.95}Sr_{0.05}\{(Mg_{0.70}Ni_{0.30})_{1/3}Nb_{2/3}\}_{0.12}Ti_{0.45}Zr_{0.43}O_3$ | 1.53 | 2.4 |
| Ex10 | $Pb_{0.90}Ba_{0.10}\{(Mg_{0.70}Ni_{0.30})_{1/3}Nb_{2/3}\}_{0.12}Ti_{0.45}Zr_{0.43}O_3$ | 1.51 | 2.3 |
| Ex11 | $Pb_{0.85}Ba_{0.075}Ca_{0.075}\{(Mg_{0.70}Ni_{0.30})_{1/3}Nb_{2/3}\}_{0.12}Ti_{0.45}Zr_{0.43}O_3$ | 1.44 | 2.2 |

(Examples 12, 13)

Piezoelectric devices were manufactured in the same manner as in Example 1 described above except that piezoelectric materials were used so as to obtain compositions of the resultant piezoelectric portions as shown in Table 8. It is to be noted that the composition of the resultant piezoelectric portion was uniform.

(Evaluation)

In each of the piezoelectric devices of Examples 12 and 13, a flexural displacement fluctuation was 2.5% or less, and comparatively small. However, in the piezoelectric device of Example 12 provided with a piezoelectric portion in which 0.8 mol% of Pb was replaced with La, the flexural displacement was 1.51 $\mu$m, and large as compared with the piezoelectric device of Example 8 provided with the piezoelectric portion in which a part of Pb was not replaced with La. On the other hand, in the piezoelectric device of Example 13 provided with a piezoelectric portion in which 1.5 mol% of Pb was replaced with La, the flexural displacement was 1.43 $\mu$m, and small as compared with the piezoelectric device of Example 8. Results are collectively shown in Table 8.

[Table 8]

| | Piezoelectric portion | Flexural displacement ($\mu$m) | Flexural displacement fluctuation (%) |
|---|---|---|---|
| Ex.8 | $Pb_{1.01}\{(Mg_{0.75}Ni_{0.25})_{1/3}Nb_{2/3}\}_{0.12}Ti_{0.45}Zr_{0.43}O_3$ | 1.48 | 2.2 |
| Ex12 | $Pb_{0.992}La_{0.008}\{(Mg_{0.75}Ni_{0.25})_{1/3}Nb_{2/3}\}_{0.12}Ti_{0.45}Zr_{0.43}O_3$ | 1.51 | 2.5 |
| Ex13 | $Pb_{0.987}La_{0.015}\{(Mg_{0.75}Ni_{0.25})_{1/3}Nb_{2/3}\}_{0.12}Ti_{0.45}Zr_{0.43}O_3$ | 1.43 | 2.7 |

As described above, according to the present invention, there can be provided a piezoelectric device which has a remarkably high piezoelectric characteristic and which is superior in vibration transmitting property between a substrate made of a ceramic and a piezoelectric portion and in which linearity of a flexural displacement with respect to an electric field is high and which has a high durability even during use with a large flexural displacement for a long period. The piezoelectric device of the present invention is preferably usable as an actuator, a dense small-sized dielectric device, a condenser as a pyroelectric device, a sensor or the like.

**Claims**

1. A piezoelectric device comprising:

   a substrate made of a ceramic;
   a piezoelectric portion made of a first piezoelectric porcelain composition containing as a major component a first $Pb(Mg, Ni)_{1/3}Nb_{2/3}O_3$-$PbZrO_3$-$PbTiO_3$ ternary solid solution system composition represented by the following formula (1); and
   an electrode electrically connected to the piezoelectric portion,
   the piezoelectric portion being solidly attached on the substrate directly or via the electrode,

$$Pb_x\{(Mg_{1-y}Ni_y)_{(1/3)}\times_aNb_{2/3}\}_bTi_cZr_dO_3 \ldots (1),$$

   wherein $0.95 \leq x \leq 1.05$, $0.20 < y \leq 0.50$, $0.90 \leq a \leq 1.10$, and b, c and d are decimals (with the proviso that (b+c+d) = 1.000) in a range surrounded with (b, c, d) = (0.550, 0.425, 0.025), (0.550, 0.325, 0.125), (0.375, 0.325, 0.300), (0.050, 0.425, 0.525), (0.050, 0.525, 0.425), and (0.375, 0.425, 0.200) in a coordinate whose coordinate axes are the b, c, and d.

2. The piezoelectric device according to claim 1, comprising:

   a plurality of piezoelectric portions; and
   a plurality of electrodes,
   the plurality of piezoelectric portions being alternately sandwiched and laminated between the electrodes, and
   a lowermost piezoelectric portion positioned in a lowermost layer among the piezoelectric portions being solidly attached onto the substrate directly or via a lowermost electrode positioned in the lowermost layer among the electrodes.

3. The piezoelectric device according to claim 1 or 2, wherein the piezoelectric portion is formed by successively laminating and sintering a second piezoelectric porcelain composition containing as a major component a second $Pb(Mg, Ni)_{1/3}Nb_{2/3}O_3$-$PbZrO_3$-$PbTiO_3$ ternary solid solution system composition represented by the following formula (2), and a third piezoelectric porcelain composition containing as a major component a $PbMg_{1/3}Nb_{2/3}O_3$-$PbZrO_3$-$PbTiO_3$ ternary solid solution system composition represented by the following formula (3) and containing 0.1 to 3.0% by mass of NiO,

$$Pb_x\{(Mg_{1-y}Ni_y)_{(1/3)}\times_aNb_{2/3}\}_bTi_cZr_dO_3 \ldots (2),$$

   wherein $0.95 \leq x \leq 1.05$, $0.05 \leq y \leq 0.20$, $0.90 \leq a \leq 1.10$, and b, c, and d are decimals (with the proviso that (b+c+d) = 1.000) in a range surrounded with (b, c, d) = (0.550, 0.425, 0.025), (0.550, 0.325, 0.125), (0.375, 0.325, 0.300), (0.050, 0.425, 0.525), (0.050, 0.525, 0.425), and (0.375, 0.425, 0.200) in a coordinate whose coordinate axes are the b, c, and d,

$$Pb_x(Mg_{y/3}Nb_{2/3})_aTi_bZr_dO_3 \ldots (3),$$

   wherein $0.95 \leq x \leq 1.05$, $0.95 \leq y \leq 1.05$, and a, b, and c are decimals (with the proviso that a+b+c = 1.00) in a range surrounded with (a, b, c) = (0.550, 0.425, 0.025), (0.550, 0.325, 0.125), (0.375, 0.325, 0.300), (0.050, 0.425, 0.525), (0.050, 0.525, 0.425), and (0.375, 0.425, 0.200) in a coordinate whose coordinate axes are the a, b, and c.

**4.** The piezoelectric device according to any one of claims 1 to 3, wherein the first piezoelectric porcelain composition is crystal grains having an average grain diameter of 1 to 10 $\mu$m and a maximum grain diameter of five times or less as much as the average grain diameter.

**5.** The piezoelectric device according to claim 4, wherein grains (NiO grains) containing NiO as a major component are present inside the crystal grains, or in the surfaces or the insides of the crystal grains.

**6.** The piezoelectric device according to claim 5, wherein the NiO grains contain MgO as solid solution.

FIG.1(a)

FIG.1(b)

FIG.2(a)

FIG.2(b)

EP 1 684 364 A2

FIG.3(a)

FIG.3(b)

FIG.4(a)

FIG.4(b)

FIG.5(a)

FIG.5(b)

FIG.6

FIG.7

23

FIG.8

FIG.9

FIG.10